# EUROPEAN PATENT APPLICATION

(11) **EP 3 944 454 A1**
(43) Date of publication of application: **26.01.2022**
(21) Application number: 20187208.2
(22) Date of filing: 22.07.2020
(51) Int. Cl.: H02J 7/00, B60L 3/00, H05K 1/16

(54) **PRE-CHARGE UNIT FOR CHARGING A DC LINK CAPACITOR AND BATTERY SYSTEM COMPRISING THE SAME**

(71) Applicant: Samsung SDI Co., Ltd., Gyeonggi-do 17084 (KR)
(72) Inventor: Maxl, Florian, 8020 Graz (AT)
(74) Representative: Gulde & Partner

(57) **Abstract**

The present invention refers to a pre-charge unit (10) for a battery system including a plurality of battery cells for charging a DC link capacitor. The pre-charge unit (10) comprises a printed circuit board (20) with at least one conductive layer (22, 24). Further, the pre-charge unit (10) comprises a pre-charge switch (30) mounted on the printed circuit board (20). Further, a pre-charge resistor (40) is electrically connected in series with the pre-charge switch (30). The pre-charge resistor (40) is formed by a conductive trace (42, 44) in the at least one conductive layer (22, 24) of the printed circuit board (20). Further, a pre-charge circuit (80) and a battery system (100) is disclosed.

## Description

### Field of the Invention

The present invention relates to a pre-charge unit for a battery system including a plurality of battery cells for charging a DC link capacitor, a pre-charge circuit and a battery system comprising the same.

### Technological Background

In recent years, vehicles for transportation of goods and people have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator in combination with an electric motor. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development. Rechargeable batteries may be used as a battery unit formed of a plurality of battery cells coupled in series and/or in parallel so as to provide a high energy density, in particular for motor driving of a hybrid vehicle. That is, the battery unit is formed by interconnecting the electrode terminals of the plurality of unit battery cells depending on a required amount of power and in order to realize a high-power rechargeable battery.

A battery pack is a set of any number of (preferably identical) battery cells. They may be configured in a series, parallel or a mixture of both to deliver the desired voltage, capacity, or power density. Components of battery packs include the individual battery units and interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers.

Battery systems usually comprise a battery management system (BMS) and/or battery management unit (BMU) for processing the aforementioned information. The BMS/BMU may communicate to the controllers of the various electrical consumers via a suitable communication bus, e.g. a SPI or CAN interface. The BMS/BMU may further communicate with each of the battery subunits, particularly with a cell supervision circuit (CSC) of each battery subunit. The CSC may be further connected to a cell connection and sensing unit (CCU) of a battery subunit that interconnects the battery cells of the battery subunit.

Thus, the BMS/BMU is provided for managing the battery pack, such as by protecting the battery from operating outside its safe operating area, monitoring its state, calculating secondary data, reporting that data, controlling its environment, authenticating it and/or balancing it.

Conventionally, when electrically connecting a battery voltage source of a battery system including a plurality of battery cells to a load, a so called DC link capacitor that is connected parallel and intermediate to the load is charged before the main contactors/switches are closed. The reason for this is that a charged DC link capacitor prevents high current peaks during the closing of the main contactors. Such high current peaks can be very harmful for the contractors.

According to the state of the art, an ohmic pre-charge resistor with typical resistances of 10 Ω up to 100 Ω is used and electrically interconnected between the battery voltage source, i. e. the plurality of coupled battery cells, and the DC link capacitor. When the DC link capacitor is sufficiently charged, the main capacitors can be closed and the current peaks are reduced. The ohmic resistor is typically a high power device and often enclosed in ceramics. Alternatively, it can be formed as a copper wire that is wound around a ceramic core.

The problem arising from these known solutions is that a conventional pre-charge resistor consumes space, in particular in the HV battery system enclosure. Further, it requires separate wires and connectors to the bus bars of the plurality of battery cells. This implementation also leads to higher costs.

It is thus an object of the present invention to overcome or reduce at least some of the drawbacks of the prior art and to provide a pre-charge unit and a battery system which can be compactly integrated thereby reducing volume space but still provides sufficient resistance to limit the switching currents. Further solved objective problems will become clearer from the following description.

### Summary of Invention

Embodiments of the present disclosure seek to solve at least one of the problems existing in the prior art at least to some extent. In particular, a pre-charge unit for a battery system including a plurality of battery cells for charging a DC link capacitor is provided. The pre-charge unit comprises a printed circuit board with at least one conductive layer. The pre-charge unit further comprises a pre-charge switch mounted on the printed circuit board. The pre-charge unit comprises a pre-charge resistor electrically connected in series with the pre-charge switch. The pre-charge resistor is formed by a conductive trace in the at least one conductive layer of the printed circuit board.

The ohmic resistance of the conductive trace may be set or defined by the width, thickness and the trace length of the resistance trace. These parameters may be selected in advance, that is in the manufacturing process, in order to tailor the required resistance value. The pre-charge switch may be a pre-charge relay to switch high voltages, e.g. more than 100 V or more than for example 400 V. Mounted on may be in other words attached to. A conductive trace may be preferably a copper trace, i.e. comprising copper. The conductive trace may also be referred to as conductive tracks.

The technical advantage of the invention is that the resistance is integrated in the printed circuit board together with the pre-charge switch such that space and costs for cables are reduced, since no separate resistor-components and connecting cables are required. In particular, the printed circuit board which is required for the pre-charge switch is by the present invention also used to implement the resistor. Thus, the invention provides in combination with the pre-charge switch an efficient use of the printed circuit board.

In a preferred embodiment, the conductive trace in the conductive layer may be formed to comprise a plurality of parallel aligned strip portions. Trace length of the conductive trace may be maximized in this manner.

Preferably, a width of the conductive trace in the conductive layer is larger than a distance between two parallel strip portions. Then, the trace length of the conductive trace may be increased and thus sufficient electric resistance can be achieved. A high occupation area in case of printed circuit boards with a single conductive layer, e.g. above 50% or more, of the conductive traces with respect to the printed circuit board may be achieved.

In a preferred embodiment, the conductive trace may be formed to comprise wound end portions electrically connecting two adjacent strip portions. A steady, i.e. continuous, conductive trace is formed which meanders through the area of the conductive layer.

Preferably, the wound end portions may be positioned at an edge portion of the printed circuit board. The trace length of the conductive trace can be enhanced, which can be used to implement higher values for the electric resistance. In other words, the positioning of the wound end portions may also be positioned at an edge portion of the conductive layer.

Preferably, the conductive trace of the pre-charge resistor may be thermally coupled to a cooling plate disposed on at least one side of the conductive trace. A temperature rise and possible damage due to high temperatures due to resistive heating at the conductive traces may thus be prevented.

In a preferred embodiment, the printed circuit board may comprise at least two conductive layers each comprising a conductive trace and being vertically disposed on each other, wherein the pre-charge resistor is formed by the at least two conductive traces. Due to the two conductive layers, the trace length and thus the resistance value of the conductive trace may be beneficially increased. Also, occupied area of each conductive layer by the conductive trace can be reduced.

Preferably, the conductive traces of different conductive layers are electrically connected in series by at least one electrically conductive vertical interconnect access unit, which vertically penetrates through at least one insulating layer interposed between the different conductive layers. The vertical interconnect unit may in particular be a vertical interconnect access, also referred to as via or VIA. The concept of a vertical interconnect unit is hereby transferred in order to increase the electrical resistance of the combined conductive trace by providing a direct connection through one or more insulating layers. Due to the vertical interconnect units, the trace length and thus the resistance of the connected trace may be enhanced or the occupation area of the conductive trace in each conductive layer may be reduced.

The at least one vertical interconnect unit may be positioned at an end portion of the conductive layers of the printed circuit board. The vertical interconnect units positioned at the end portion allows to achieve a maximum trace length in each conductive layer. Each conductive trace can be optimally used and maximum electrical resistance may be achieved.

In a preferred embodiment, a number of conductive layers each comprising a conductive trace may be two, or in an alternative embodiment, a number of conductive layers each comprising a conductive trace may be uneven. Two conductive layers may be a preferred embodiment since the complexity rises with the number of conductive layers. When the number of conductive layers is uneven, the trace end portions may be positioned on different ends of the printed circuit board. Thus, the conductive traces can be readily electrically coupled readily, e.g. to the pre-charge switch.

In a preferred embodiment, a fraction of an occupied area of the conductive layer occupied by the conductive trace compared to the area of the conductive layer at the pre-charge resistor is less than 50%. The wording of compared to may refer to a fraction of the area of the conductive layer and the area of the conductive trace. Therefore, when two or more conductive layers are used, the trace length can be reduced and thus also the occupation area covered by the conductive trace can be made having less occupation density. For example, the occupation area in the case of two conductive layers by the conductive traces may be for example 74 cm², but the invention is not restricted thereto.

In another aspect of the invention, a pre-charge circuit for charging a DC link capacitor is disclosed, comprising a pre-charge unit according to one of the above embodiments and a plurality of battery cells electrically connected to the pre-charge switch of the pre-charge unit. In a preferred embodiment, the control unit may be configured to open the pre-charge switch of the pre-charge unit based on a charging time being above a predetermined charging time, wherein the predetermined charging time is based on the voltage of the battery cells and the resistance of the conductive trace. This allows preventing overheating of the conductive traces and thereby of the pre-charge resistor. In particular, insight is that Joule heating will depend on applied voltage, i.e. overall or terminal voltage, of the plurality of battery cells and the selected resistance value of the resistance trace. Then, the control unit may calculate/determine a corresponding maximum charging time. Such finite charging time may lead to a not fully charged DC link capacitor. However, it may be sufficient to prevent high current peaks while the integrity of the circuit is guaranteed. The maximum charging time may preferably be less than 10 to 100 ms for voltages of above 100 V or 400 V, but the invention is not restricted thereto.

In another aspect of the invention, a battery system comprising a pre-charge circuit and/or a pre-charge unit may be provided. In particular, a main switch and the pre-charging unit may be connected in parallel.

According to another aspect of the present invention, a vehicle may include a battery system according to one of the above embodiments.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a schematic view of a pre-charge unit and a battery system according to an embodiment of the present invention;
- Fig. 2: illustrates a top view perspective of a part of the pre-charge resistor according to an embodiment of the present invention;
- Fig. 3: illustrates a perspective view of a part of the pre-charge unit according to another embodiment of the present invention; and
- Fig. 4: illustrates a side view perspective of a part of the pre-charge unit according to another embodiment of the present invention.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

It will also be understood that when a film, a region, or an element is referred to as being "above" or "on" another film, region, or element, it can be directly on the other film, region, or element, or intervening films, regions, or elements may also be present.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present invention should not be construed as being limited thereto.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

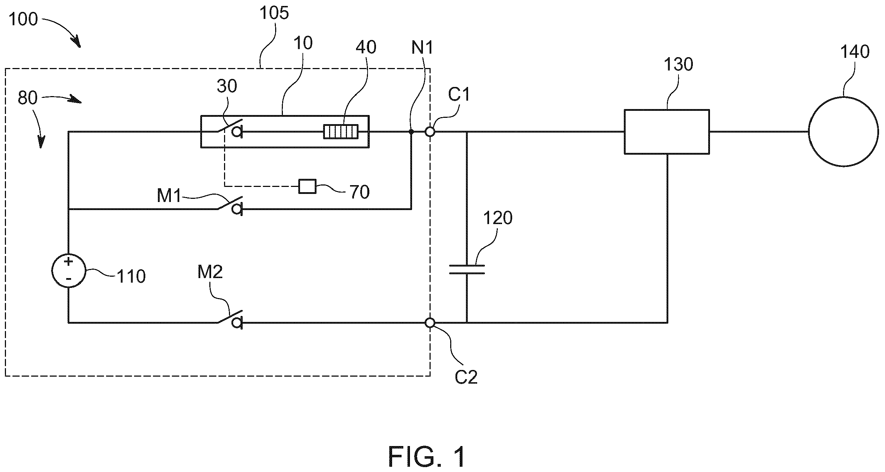

Fig. 1 shows a schematic view of a battery system 100 with a pre-charge circuit 80 and a pre-charge unit 10 integrated in the battery system 100 according to an embodiment of the present invention.

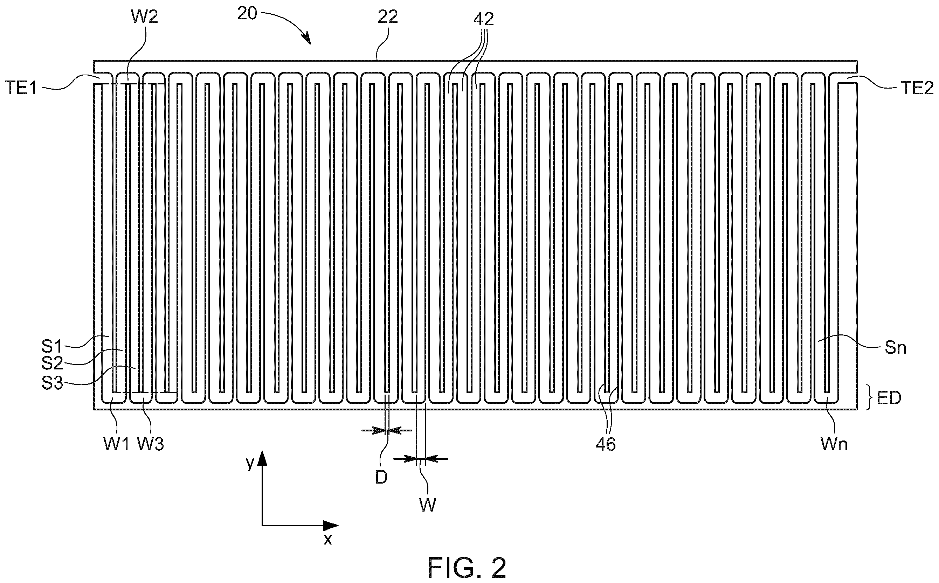

The pre-charge unit 10 according to the present invention will be described in more details in the Figs. 2 to 4 according to embodiments of the invention.

The battery system 100 may comprise the pre-charge circuit 80. The battery system 100 may further comprise a plurality of battery cells 110. The plurality of battery cells 110 are shown in Fig. 1 as battery voltage source for compactness. The plurality of battery cells 110 may also be part of the pre-charge circuit 80.

The battery system 100 may be accommodated in a battery enclosure 105. The battery system 100 may have electrical contacts C1, C2 to be electrically connected to load 140 and to supply the load with electrical power. In D1, the load 140 may preferably be a motor, but the invention is not restricted thereto.

Only for an exemplary illustration, an inverter 130 may be interconnected between electrical contacts C1, C2 and the load 140. The inverter 130 may transform the output voltage generated by the plurality of battery cells 110 to a voltage required by the corresponding load 140. The inverter 130 may be in this case a DC/DC converter.

The battery system 100 may be connected to an external DC link capacitor 120. A DC link capacitor may be in other words an intermediate capacitor to a load 140. The DC link capacitor 120 may further be electrically connected to the load 140, e.g. via the inverter 130, see Fig. 1. Here, the DC link capacitor 120 may be electrically connected to the electrical contacts C1, C2 of the battery system 100.

The battery system 100 may comprise a first main switch M1. The battery system 100 may further comprise a second main switch M2. In some embodiments, the second main switch M2 may be omitted. The main switches M1, M2 may preferably be relays to switch high voltages, e.g. above 100 V, above 400 V or more. When the first main switch M1 or the first and the second main switches M1, M2 are a conductive state, i.e. a closed state, the main switches may electrically connect the plurality of battery cells 110 to the load 140. A control unit 70 may be provided which is configured to control the switches M1, M2. The control unit 70 may be a microcontroller. The microcontroller may be part of the battery management system.

When the external DC link capacitor 120 is sufficiently charged, the main switches M1, M2 may be closed without the generation of high current peak which may damage or even destroy the main switches M1 or M2. In other words, a charged DC link capacitor 120 may prevent the high current peaks upon closing the first main switch M1 and/or the second main switch M2.

The charging of the DC link capacitor 120 has to occur in a previous step before the step of closing the main switches M1, M2.

Therefore, the battery system 100 comprises an additional pre-charge circuit 80, which will be explained in more detail below.

In particular, the battery system 100 and the pre-charge circuit 80 comprise a pre-charge unit 10 for charging the DC link capacitor 120. The pre-charge unit 10 and the first main switch M1 may be connected in parallel and electrically connected to the plurality of battery cells 110. Further, the pre-charge unit 10 and the main switch M1 may be electrically connected to the node N1, the node N1 electrically connected to the external DC link capacitor for charging the DC link capacitor 120 and electrically connected to the load 140 to supply power depending on the switching state of the first main switch M1 and depending of the state of the pre-charge unit 10.

The pre-charge unit 10 according to the present invention will now be described in more detail. The pre-charge unit 10 may comprises a pre-charge switch 30. The pre-charge switch 30 may be controlled by the control unit 70 to charge the DC link capacitor 120. The pre-charge switch 30 may be electrically connected to the plurality of battery cells 110. When a second switch M2 is provided, for pre-charging also the second switch M2 may be set conductive by the control unit 70.

The pre-charge unit 10 according to the present invention comprises a printed circuit board 20 as schematically indicated in Fig. 1. The pre-charge switch 30 is herein mounted on, or attached to, the printed circuit board 20.

Further, the printed circuit board 20 comprises a conductive layer 22, 24, see for example Figs. 2 to 4 disclosing several embodiments of the invention. In embodiments, one or more conductive layers 22, 24 may be formed in the printed circuit board 20. In at least one conductive layer 22, 24 a conductive trace 42, 44 is formed. Preferably, the conductive trace 42, 44 may be a copper trace.

The pre-charge resistor 40 is formed by the conductive trace 42, 44 in the at least one conductive layer 22, 24 of the printed circuit board 20, as it is schematically indicated in Fig. 1 and will be more clearly shown in the following figures. The pre-charge resistor 40 formed by the conductive trace 42, 44 is electrically connected in series with the pre-charge switch 30. The resistance value of each conductive trace 42 can be defined by its length, width and thickness.

According to the present invention, the resistance for limiting currents is integrated in the printed circuit board 20 together with the pre-charge switch 30. That means that no separate resistor has to be provided. Also, no extra resistor has to be mounted to the printed circuit board 20 and connected with wires. Thereby, space and costs for cables are reduced, since no separate resistor-components and connecting cables are needed. The printed circuit board 20 thus is highly efficiently used when the pre-charge switch 30 is installed in the printed circuit board 20 and the resistor is implemented by the conductive traces. Existing resources are thus used efficiently. In particular, the battery enclosure 105 sets a certain volume for the inner space and components. The solution brings the advantage of spatial compactness, which is highly important when implementing battery systems in applications.

Fig. 2 shows a cross section in top view perspective of a printed circuit board 20 in which the pre-charge resistor 40 used in the pre-charge unit 10 according to an embodiment the present invention is formed. The viewed plane may be spanned by an x- and a y-coordinate.

The cross section shows a conductive layer 22 of the printed circuit board 20. The conductive layer 22 comprises a conductive trace 42 forming the pre-charge resistor 40. In an embodiment, the conductive trace 42 may comprise copper.

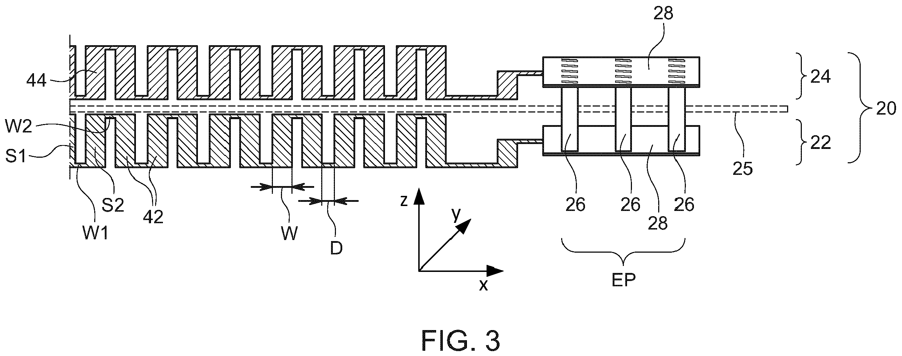

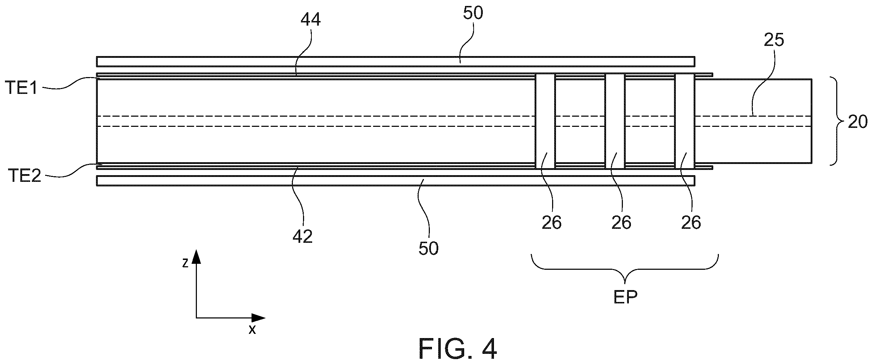

In the present example of Fig. 2, the printed circuit board 20 comprises one conductive layer 22. However, the present invention is not restricted thereto, see for example below the embodiments of Figs. 3 and 4, in which more than one conductive layer 22, 24 are implemented.

It is hereby noted, that for very high voltages of the plurality of battery cells 110 imply high currents. Thus, for higher voltages also higher resistances are required. Therefore, the invention also aims to provide sufficient resistance to limit the current also for higher battery voltages. For example, the resistances may be about 10 Ω up to 100 Ω or up to 1000 Ω, while voltages larger than 100 V or larger than 400 V may be used.

The conductive trace 42 in the conductive layer 22 may be formed to comprise a plurality of parallel aligned strip portions S1, ..., Sn. Adjacent strip portions Si, Si+1 with 1<i<n-1 may carry an electric current with mutually reverse direction. The strip portions S1, ..., Sn may form the main contribution to the electrical resistance of the conductive trace 42 which results in an efficient limitation of the electric current peaks in response to a closing of the pre-charge switch 30.

Also, in this example and as can be viewed as well in Fig. 3, a width W of the conductive trace 42 in the conductive layer 22 may be larger than a distance D between two parallel strip portions Si, Si+1 for 1 <i<n-1. The space between adjacent strip portions Si, Si+1 may comprise an insulator 46 which electrically separates the strip portions S1, ..., Sn from their adjacent strip portion. The short distance D implies that only narrow gaps between the strip portions S1, ..., Sn are generated and the trace length of the conductive trace 42 may be increased since the number of strip portions S1, ..., Sn for a fixed length may be higher. Thus, the resistive length of the conductive trace 42 may be enhanced.

The conductive trace 42 may be further formed to comprise wound end portions W1, ..., Wn. Each wound end portion W1, ..., Wn may electrically connect two adjacent strip portions Si, Si+1. The wound end portions may have at least a curved section or may be entirely curved. The wound end portions W1, ..., Wn may provide 180° degree turn of the conductive trace 42. The wound end portions W1, ..., Wn lead to that the conductive trace meanders over the entire area of the conductive layer 22. In particular, wound end portions W1, ..., Wn may be positioned at an edge portion ED of the printed circuit board 20. Also, this feature may efficiently use the available geometrical area/space, in particular a width of the printed circuit board 20 and/or the conductive layer 22 to increase the trace length of each strip portion S1, ..., Sn and then thereby the conductive trace 42.

The conductive trace 42 may be formed that a fraction of an occupied area of the conductive layer 22/printed circuit board 22 occupied by the conductive trace 42 in plan view compared to the area of the conductive layer 22, 24 at the pre-charge resistor 40 may be above 50%, e.g. and in particular in the case of only one conductive layer 22. The area provided by the printed circuit board 20, in particular, the conductive layer 22 may then efficiently be used for forming the resistance of the pre-charge resistor 40 according to the present invention.

Since the printed circuit board 20 according to the present embodiment includes only one conductive layer 22, the conductive trace 42 may comprise two trace end portions TE1, TE2 on opposite sides for connecting the conductive trace 42 with the pre-charge switch 30 and the wirings to the load 140. The trace end portions TE1, TE2 may be positioned at opposing ends of the pre-charge resistor 40. The trace end portions TE1, TE2 may be positioned on opposite sides with respect to the strip portions S1, ..., Sn and including the strip portions S1, ..., Sn therein between, but the invention is not restricted thereto.

The pre-charge circuit 80 may include the plurality of battery cells 110. Further, the pre-charge circuit 80 may comprise the control unit 70 configured to open, i.e. set nonconductive, the pre-charge switch 30 of the pre-charge unit 10 based on a charging time being above a predetermined charging time. That is, the conductive trace 42 on the printed circuit board 20 may be heated up due to resistive heating. The predetermined charging time may be calculated based on the voltage, i. e. the overall voltage, of the plurality of battery cells 110 and the resistance of the conductive trace 42. The control unit 70 may be a microprocessor, e.g. of the battery management system. The predetermined charging time may be in the range of less than 100 ms, preferably less than 50 ms or even less than 10 ms. Due to the individualized predetermined charging time, the charging time can be adjusted such that high temperature risks at the conductive trace 42 are reduced.

Figs. 3 and 4 disclose a pre-charge resistor 40 according to another embodiment of the invention. In particular, Fig. 3 shows a perspective view which may be spanned by x,y and z-coordinates while Fig. 4 shows a side view of the pre-charge resistor 40. The plane of the side view may be spanned by x- and z-coordinates.

In this preferred embodiment, the printed circuit board 20 may comprise two conductive layers 22, 24, wherein each conductive layer 22, 24 includes a conductive trace 42, 44 as illustrated in particular in both Figs. 3 and 4. The pre-charge resistor 40 is formed by the conductive traces 42, 44, such that high resistances may be generated.

In other embodiments of the invention, the number of conductive layers 22, 24 each comprising a conductive trace 42, 44 may be three or four, but the invention is not restricted thereto. The conductive layers 22, 24 may be vertically disposed on each other, as can be seen in both Figs. 3 and 4. The pre-charge resistor 40 is then formed by the two conductive traces 42, 44. Each of the conductive traces 42, 44 may be formed in principle in the same manner as the embodiments disclosed according to the previous embodiments of the Figs. 1 and 2.

The conductive traces 42, 44 of the two different conductive layers 22, 24 may be electrically connected in series. Then, the trace length of the common conductive trace 22, 24 may be approximately doubled. At least one electrically conductive vertical interconnect unit 26 may be provided. In the present case, three vertical interconnect units 26 are provided, but the invention is not restricted thereto. The vertical interconnect units 26, as seen in Fig. 3, may vertically penetrate through at least one insulating layer 25 which is interposed between the conductive layers 22, 24. The conductive layers 22, 24 may each comprise an electrically conductive connector plate 28 to which the vertical interconnect access unit 26 may be respectively connected to. The trace length of the conductive trace is then increased. This allows for producing higher resistance. In other terms, also the occupation area of the conductive trace 42, 44 per conductive layer 22, 24 may be reduced due to the use of two traces.

The vertical interconnect unit 26 may be positioned at an end portion EP of the conductive layers 22, 24. For example, each of the three vertical interconnect units 26 is formed at an end portion EP. Then, the full conductive trace 42, 44 of each conductive layer is 22, 24 can be used in full length.

In the present embodiment, the trace end portions T1, T2 may be positioned on the same side with respect to the strip portions S1, ...m Sn of the conductive traces 42, 44, see for exemplary the Fig. 4. In an embodiment of the invention, a number of conductive layers 22 each comprising a conductive trace 42 may be uneven, for example 3, 5 or 7 or 1 in accordance with Fig. 2. Then, the trace end portions may be positioned on opposite sides similar as shown in Fig. 1.

Due to the use of more than one conductive layer 22 for providing a resistance, the conductive layer 22 may be formed such that a fraction of an occupied area of the conductive layer 22/printed circuit board 22 occupied by the conductive trace 42 in plan view compared to the area of the conductive layer 22, 24 at the pre-charge resistor 40 may be less than 50%. Due to the two or more conductive layers, in this embodiment, the trace length per conductive layer 22, 24 may be reduced compared to the case, where only one conductive layer is used, see e.g. Fig. 2. The loss of trace length per conductive layer 22, 24 is overcompensated by the series connections of the conductive traces 22, 24 of different conductive layers 42, 44.

As can be seen in Fig. 4, the conductive trace 42, 44 of the pre-charge resistor 40 is thermally coupled to a cooling plate 50. The cooling plate 50 may be disposed on at least one side of the conductive trace 42, 44. The pre-charge resistor 40 may be thermally coupled to a cooling plate 50 disposed on at least one side of the printed circuit board 20. As shown in Fig. 4, such cooling plate 50 may be placed on both sides of the of the printed circuit board 20 at least at the conductive traces 42, 44 to effectively transport heat created due to Joule-heating when current is transported through conductive traces 42, 44. A cooling plate 50 may also be used in the embodiment of Fig. 2 thereby preventing high temperature states.

### Reference signs

- 10: pre-charge unit

- 20: printed circuit board
- 22: conductive layer
- 24: conductive layer
- 25: insulating layer
- 26: vertical interconnect unit
- 28: connector plate

- 30: pre-charge switch

- 40: pre-charge resistor
- 42: conductive trace
- 44: conductive trace
- 46: insulator

- 50: cooling plate
- 70: control unit
- 80: pre-charge circuit

- 100: battery system
- 105: enclosure
- 110: battery cells

- 120: DC link capacitor

- 130: inverter

- 140: load

- C1: electrical contact
- C2: electrical contact

- N1: node

- S1, ..., Sn: strip portion
- W1, ..., Wn: wound end portions
- ED: edge portion

- W: width
- D: distance

- M1: main switch
- M2: main switch

- EP: end portion

- TE1: trace end portion
- TE2: trace end portion

## Claims

1. A pre-charge unit (10) for a battery system including a plurality of battery cells for charging a DC link capacitor, comprising:
a printed circuit board (20) comprising at least one conductive layer (22, 24);
a pre-charge switch (30) mounted on the printed circuit board (20);
a pre-charge resistor (40) electrically connected in series with the pre-charge switch (30); and
the pre-charge resistor (40) is formed by a conductive trace (42, 44) in the at least one conductive layer (22, 24) of the printed circuit board (20).

2. The pre-charge unit (10) of claims 1, wherein the conductive trace (42, 44) in the at least one conductive layer (22, 24) is formed to comprise a plurality of parallel aligned strip portions (S1, ..., Sn).

3. The pre-charge unit (10) of claim 2, wherein a width (W) of the conductive trace (42, 44) in the at least one conductive layer (22, 24) is larger than a distance (D) between two parallel strip portions (S1, ..., Sn).

4. The pre-charge unit (10) of one of the claims 2 to 3, wherein the conductive trace (42, 44) is formed to comprise wound end portions (W1, ..., Wn) electrically connecting two adjacent strip portions (S1, ..., Sn).

5. The pre-charge unit (10) of claim 4, wherein the wound end portions (W1, ..., Wn) are positioned at an edge portion (ED) of the printed circuit board (20).

6. The pre-charge unit (10) of one of the claims 1 to 5, wherein the conductive trace (42, 44) of the pre-charge resistor (40) is thermally coupled to a cooling plate (50) disposed on at least one side of the conductive trace (42, 44).

7. The pre-charge unit (10) of one of the claims 1 to 6, wherein the printed circuit board (20) comprises at least two conductive layers (22, 24) each comprising a conductive trace (42, 44) and being vertically disposed on each other, wherein the pre-charge resistor (40) is formed by the conductive traces (42, 44).

8. The pre-charge unit (10) of claim 7, wherein the conductive traces (42, 44) of different conductive layers (22, 24) are electrically connected in series by at least one electrically conductive vertical interconnect unit (26), which vertically penetrates through at least one insulating layer (25) interposed between the different conductive layers (22, 24).

9. The pre-charge unit (10) of claim 8, wherein the at least one vertical interconnect unit (26) is positioned at an end portion (EP) of the conductive layers (22, 24).

10. The pre-charge unit (10) of one of the claims 7 to 9, wherein a number of conductive layers (22, 24) each comprising a conductive trace (42, 44) is two or wherein the number of conductive layers (22) each comprising a conductive trace (42) is uneven.

11. The pre-charge unit (10) of one of the claims 7 to 10, wherein a fraction of an occupied area of the conductive layer (22, 24) occupied by the conductive trace (42, 44) compared to the area of the conductive layer (22, 24) at the conductive trace is less than 50%.

12. A pre-charge circuit (80) for charging a DC link capacitor, comprising a pre-charge unit (10) according to one of the claims 1 to 11 and a plurality of battery cells (110) electrically connected to the pre-charge switch (30) of the pre-charge unit (10).

13. The pre-charge circuit (80) according to claim 12, comprising a control unit (70) configured to open the pre-charge switch (30) of the pre-charge unit (10) based on a charging time being above a predetermined charging time, wherein the predetermined charging time is based on a voltage of the plurality of battery cells (110) and the resistance of the conductive trace (42, 44).

14. A battery system (100), comprising a pre-charge circuit (80) according to one of the claims 12 to 13.

15. A vehicle comprising a battery system (100) according to claim 14.

## Amended claims

### Amended claims in accordance with Rule 137(2) EPC.

1. A pre-charge unit (10) for a battery system including a plurality of battery cells for charging a DC link capacitor, comprising:
a printed circuit board (20);
a pre-charge switch (30) mounted on the printed circuit board (20);
a pre-charge resistor (40) electrically connected in series with the pre-charge switch (30);
**characterized in that**,
the printed circuit board (20) comprises at least one conductive layer (22, 24), and
the pre-charge resistor (40) is formed by a conductive trace (42, 44) in the at least one conductive layer (22, 24) of the printed circuit board (20).

2. The pre-charge unit (10) of claims 1, wherein the conductive trace (42, 44) in the at least one conductive layer (22, 24) is formed to comprise a plurality of parallel aligned strip portions (S1, ..., Sn).

3. The pre-charge unit (10) of claim 2, wherein a width (W) of the conductive trace (42, 44) in the at least one conductive layer (22, 24) is larger than a distance (D) between two parallel strip portions (S1, ..., Sn).

4. The pre-charge unit (10) of one of the claims 2 to 3, wherein the conductive trace (42, 44) is formed to comprise wound end portions (W1, ..., Wn) electrically connecting two adjacent strip portions (S1, ..., Sn).

5. The pre-charge unit (10) of claim 4, wherein the wound end portions (W1, ..., Wn) are positioned at an edge portion (ED) of the printed circuit board (20).

6. The pre-charge unit (10) of one of the claims 1 to 5, wherein the conductive trace (42, 44) of the pre-charge resistor (40) is thermally coupled to a cooling plate (50) disposed on at least one side of the conductive trace (42, 44).

7. The pre-charge unit (10) of one of the claims 1 to 6, wherein the printed circuit board (20) comprises at least two conductive layers (22, 24) each comprising a conductive trace (42, 44) and being vertically disposed on each other, wherein the pre-charge resistor (40) is formed by the conductive traces (42, 44).

8. The pre-charge unit (10) of claim 7, wherein the conductive traces (42, 44) of different conductive layers (22, 24) are electrically connected in series by at least one electrically conductive vertical interconnect unit (26), which vertically penetrates through at least one insulating layer (25) interposed between the different conductive layers (22, 24).

9. The pre-charge unit (10) of claim 8, wherein the at least one vertical interconnect unit (26) is positioned at an end portion (EP) of the conductive layers (22, 24).

10. The pre-charge unit (10) of one of the claims 7 to 9, wherein a number of conductive layers (22, 24) each comprising a conductive trace (42, 44) is two or wherein the number of conductive layers (22) each comprising a conductive trace (42) is uneven.

11. The pre-charge unit (10) of one of the claims 7 to 10, wherein a fraction of an occupied area of the conductive layer (22, 24) occupied by the conductive trace (42, 44) compared to the area of the conductive layer (22, 24) at the conductive trace is less than 50%.

12. A pre-charge circuit (80) for charging a DC link capacitor, comprising a pre-charge unit (10) according to one of the claims 1 to 11 and a plurality of battery cells (110) electrically connected to the pre-charge switch (30) of the pre-charge unit (10).

13. The pre-charge circuit (80) according to claim 12, comprising a control unit (70) configured to open the pre-charge switch (30) of the pre-charge unit (10) based on a charging time being above a predetermined charging time, wherein the predetermined charging time is based on a voltage of the plurality of battery cells (110) and the resistance of the conductive trace (42, 44).

14. A battery system (100), comprising a pre-charge circuit (80) according to one of the claims 12 to 13.

15. A vehicle comprising a battery system (100) according to claim 14.
